# EUROPÄISCHE PATENTSCHRIFT

(11) **EP 1 388 041 B1**
(45) Veröffentlichungstag und Bekanntmachung des Hinweises auf die Patenterteilung: **01.03.2006**
(21) Anmeldenummer: 02738013.8
(22) Anmeldetag: 30.04.2002
(51) Int. Cl.: G06F 3/033, G01R 19/25

(54) **MESSGERÄT MIT WERTEEDITOR UND ENTSPRECHENDES VERFAHREN**
MEASURING APPARATUS WITH VALUE EDITOR AND CORRESPONDING METHOD
APPAREIL DE MESURE EQUIPE D'UN EDITEUR DE VALEURS ET PROCEDE CORRESPONDANT

(30) Priorität: 18.05.2001 DE 10124371; 10.08.2001 DE 10139495
(43) Veröffentlichungstag der Anmeldung: 11.02.2004
(73) Patentinhaber: Rohde & Schwarz GmbH & Co. KG, 81671 München (DE)
(72) Erfinder: RIEGER, Angela, 80687 München (DE); LAINER, Kurt, 85551 Kirchheim bei München (DE); REIFERT, Bernhard, 84453 Mühldorf (DE); ILLICH, Valentin, 81245 München (DE); THOMA, Sebastian, 83026 Rosenheim (DE)
(74) Vertreter: Körfer, Thomas
(86) Internationale Anmeldenummer: PCT/EP2002/004760
(87) Internationale Veröffentlichungsnummer: WO 2002/095567

(56) Entgegenhaltungen:
- US-A- 4 818 931
- US-A- 4 972 138
- US-A- 5 321 420
- US-A- 5 481 741
- US-A- 5 550 747

## Beschreibung

Die Erfindung betrifft ein Meßgerät mit einem Werteeditor zur Eingabe von Werten für Einstellparameter von Funktionseinheiten des Meßgeräts über Bedienelemente, ein entsprechendes Verfahren und ein Computerprogramm zur Durchführung der Verfahrensschritte.

Zur Eingabe von Werten für Einstellparameter von Funktionseinheiten bei Meßgeräten ist es üblich einen einzustellenden Einstellparameter mittels einer zugeordneten Taste eines auf einer Frontplatte angeordneten Bedienfelds aufzurufen. Der Wert des Einstellparameters kann dann beispielsweise mittels eines Drehknopfs eingestellt werden. Dabei ist die Änderung eines eingestellten Werts des Einstellparameters nur durch eine vorgegebene Funktion vorzunehmen. Der Bediener hat keine Möglichkeit eine andere Editierfunktion zu verwenden.

In der Praxis führt dies zu einer umständlichen Handhabung des Meßgeräts, da für unterschiedliche Einsatzzwecke verschiedenartige Editierfunktionen unterschiedlich gut geeignet sind.

Zum technischen Hintergrund sei noch auf die US 5,953,009 verwiesen. Aus dieser Druckschrift geht die Zuweisung von Trigger-Funktionen an einem Meßkanal eines digitalen Oszilloskops durch Anklicken und Verschieben von die Trigger-Funktionen symbolisierenden Ikonen auf der Bedienoberfläche hervor. Der Signalfluß einzelner Funktionseinheiten und die Funktion dieser Funktionseinheiten sind auf der Bedienoberfläche jedoch nicht erkennbar und können auf der Bedienoberfläche nicht ausgewählt werden.

Weiterhin sei auf das Document US-A-4 972 138 verwiesen das die Merkmale des Oberbegriffs des Meßgerätes nach Anspruch 1 sowie ein entsprechendes Verfahren zeigt.

Es ist die Aufgabe der Erfindung, ein Meßgerät mit einem Werteeditor mit mehreren Funktionalitäten zur Eingabe von Werten von Einstellparametern sowie ein entsprechendes Verfahren und Computerprogramm zu schaffen.

Die Aufgabe wird durch das erfindungsgemäße Meßgerät mit den Merkmalen des Anspruchs 1, das erfindungsgemäße Verfahren mit den Merkmalen des Anspruchs 17 sowie das erfindungsgemäße Computerprogramm mit den Merkmalen des Anspruchs 28 oder 29 gelöst.

Das erfindungsgemäße Meßgerät weist zum Editieren der Werte der Einstellparameter unterschiedliche Editierfunktionalitäten auf, die durch eine logische Zuordnung zu den Eingabemitteln automatisch einschaltbar sind. Für den Bediener ergibt sich dabei insbesondere der Vorteil, daß eine intuitive Bedienung des Meßgeräts möglich ist. So erfolgt die Auswahl eines einzustellenden Einstellparameters nicht abstrakt durch einen Tastendruck einer zugeordneten Taste eines Bedienfelds der Frontplatte, sondern durch Markierung eines den Einstellparameter wiedergebenden Bedienblocks, in dem der Bediener alle Informationen zu einem Einstellparameter auf einen Blick erfassen kann. Die zu jedem Zeitpunkt editierbaren Einstellparameter sind auf einer Darstellungseinrichtung dargestellt, so daß der Bediener keiner hierarchischen Struktur folgend nur über eine Vielzahl von Bedientasten des Meßgeräts zu dem betreffenden Einstellparameter gelangt.

Durch die in den Unteransprüchen aufgeführten Maßnahmen sind vorteilhafte Weiterbildungen des erfindungsgemäßen Meßgeräts bzw. des erfindungsgemäßen Verfahrens möglich.

Insbesondere ist durch die automatische Auswahl eines Editiermodus durch Betätigen einer entsprechend dem aufzurufenden Editiermodus zu verwendenden Eingabemöglichkeit eine Fehlbedienung praktisch ausgeschlossen. Die Bedienung beschränkt sich auf einige wenige Bedientasten, deren Funktion sich während der Bedienung in der Praxis von selbst erschließt.

Ein Ausführungsbeispiel des erfindungsgemäßen Meßgeräts und des erfindungsgemäßen Verfahrens wird nachfolgend unter Bezugnahme auf die Zeichnungen näher beschrieben. In den Zeichnungen zeigen:
- Fig. 1: ein Blockschaltbild eines Ausführungsbeispiels eines als erfindungsgemäßes Meßgerät ausgebildeten Signalgenerators;
- Fig. 2: ein Beispiel einer Ansicht der Darstellungseinrichtung mit als Funktionsblöcken dargestellten Funktionseinheiten des Meßgeräts;
- Fig. 3: ein Beispiel einer Darstellungseinrichtung mit einem geöffneten Dialogfenster;
- Fig. 4: ein Beispiel eines Ausschnitts einer Darstellung der Darstellungseinrichtung mit einem markierten Bedienblock;
- Fig. 5: ein Beispiel eines Ausschnitts einer Darstellung bei aufgerufener erster Variationsfunktion in einem ersten Editiermodus;
- Fig. 6: ein Beispiel eines Ausschnitts einer Darstellung bei aufgerufener zweiter Variationsfunktion in einem ersten Editiermodus;
- Fig. 7: ein Beispiel eines Ausschnitts einer Darstellung bei eingeschaltetem zweiten Editiermodus;
- Fig. 8: ein Beispiel eines Ausschnitts einer Darstellung mit einer geöffneten Auswahlliste; und
- Fig. 9: eine tabellarische Übersicht über eine Mehrfachbelegung von Tasten eines Tastaturfelds.

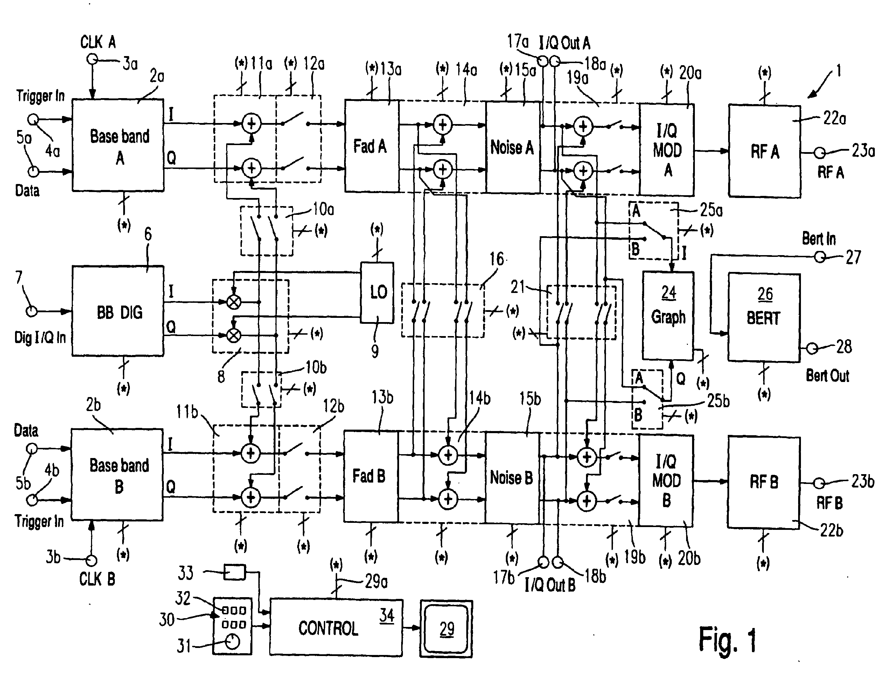

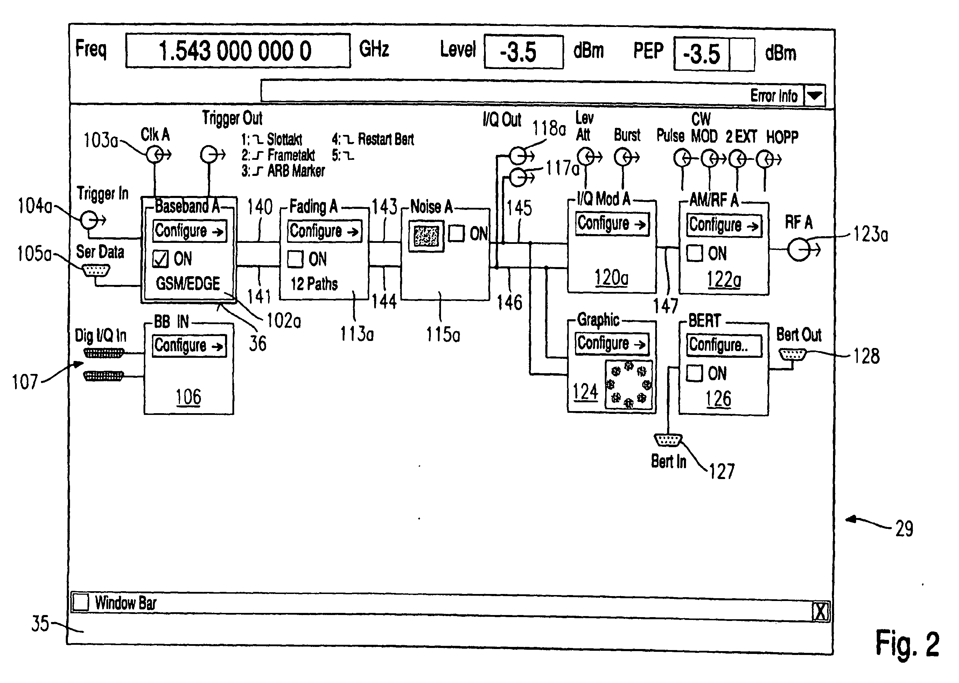

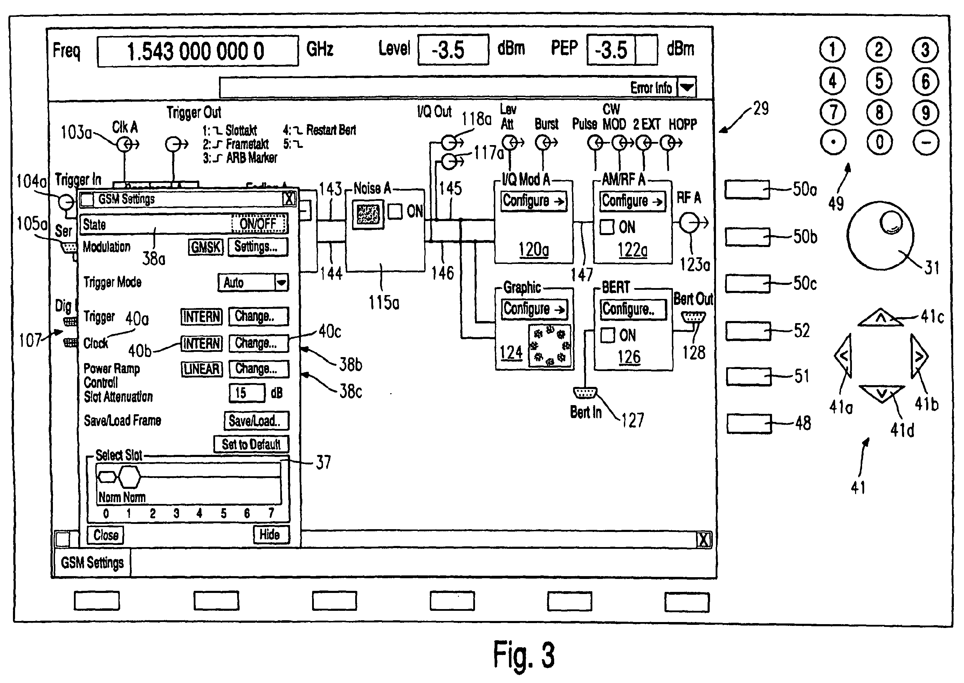

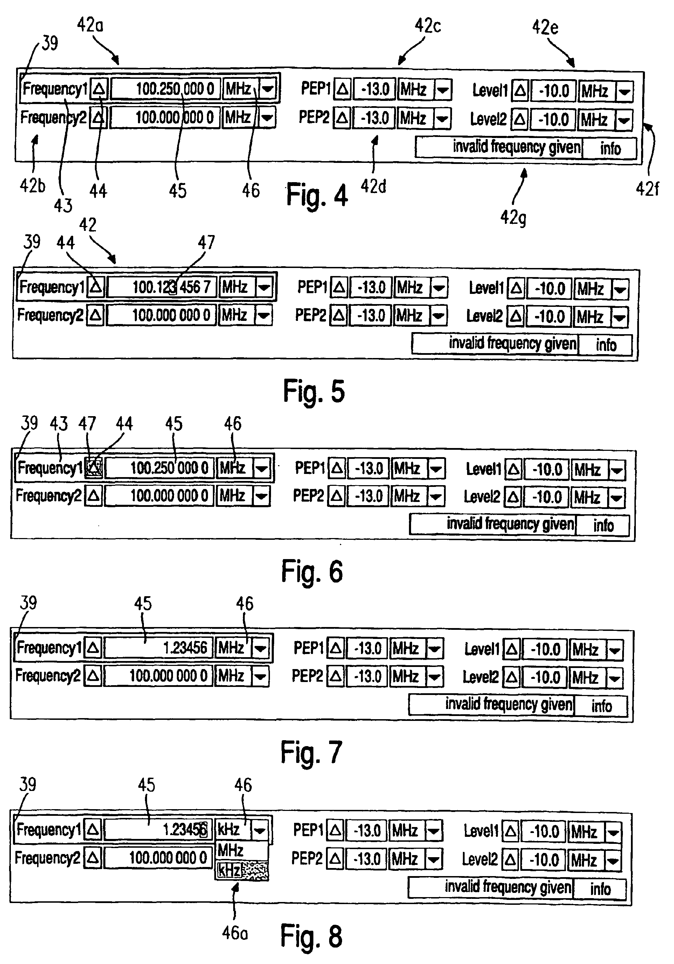

Bevor anhand der Figuren 4 bis 8 Ausführungsbeispiele der graphischen Darstellung sowie die erfindungsgemäße Funktion des Werteeditors beschrieben werden, wird zunächst anhand von Fig. 1 ein Blockschaltbild eines Signalgenerators beschrieben, der als erfindungsgemäßes Meßgerät 1 ausgebildet ist und anhand von Fig. 2 und 3 ein Beispiel auf der Darstellungseinrichtung dargestellter Funktionsblöcke sowie eines für einen Funktionsblock geöffneten Dialogfensters erläutert. Das Meßgerät 1 ist nicht zwingend ein Signalgenerator, es kann z.B. auch ein Protokolltester oder Spektrumanalysator sein.

Der Signalgenerator umfaßt eine erste Basisbandeinheit 2a und eine zweite Basisbandeinheit 2b. Die Basisbandeinheiten 2a und 2b erzeugen an ihren I- und Q-Ausgängen Basisbandsignale nach vorgegebenen, durch den Benutzer auswählbaren Standards, beispielsweise nach dem GSM-Standard, dem GSM-EDGE-Standard oder einem Weitband-CDMA-Standard. Den Basisbandeinheiten 2a, 2b sind an Buchsen 3a bzw. 3b Clock-Signale, an Buchsen 4a bzw. 4b Trigger-Signale und an Buchsen 5a bzw. 5b Modulationsdaten zuführbar. Daneben ist im dargestellten Ausführungsbeispiel eine digitale Basisbandgeneratoreinheit 6 vorhanden, die aus an einer Buchse 7 zugeführten digitalen I/Q-Werten die I- und Q-Komponente eines weiteren Basisband-Signals erzeugt. Das Ausgangssignal des digitalen Basisbandgenerators 6 kann in einer Multipliziereinheit 8, welcher die konstante Frequenz eines einstellbaren lokalen Oszillators 9 zugeführt wird, hochgesetzt werden.

Über eine Schalteinheit 10a bzw. eine zweite Schalteinheit 10b wird das ggf. hochgemischte Basisbandsignal der digitalen Basisbandgeneratoreinheit 6 einer digitalen Addiereinheit 11a oder einer digitalen Addiereinheit 11b zugeführt.

Über eine Schalteinheit 12a bzw. eine Schalteinheit 12b wird das Ausgangssignal der Basisbandeinheiten 2a und 2b bzw. der Addiereinheiten 11a und 11b einer Fadingeinheit 13a bzw. 13b zugeführt, die das Basisbandsignal mit einem Fading (variablem Schwund) beaufschlagt. Die Funktionen der Fadingeinheiten 13a und 13b, beispielsweise die Anzahl, die Zeitverzögerung und die Dämpfung der in der Fadingeinheit implementierten Signalverzögerungspfade, können durch den Benutzer festgelegt werden. Die Fadingeinheiten 13a und 13b sind über jeweils eine Addiereinheit 14a bzw. 14b mit jeweils einer Rauscheinheit 15a bzw. 15b verbunden. Die Rauscheinheiten 15a, 15b beaufschlagen das Basisbandsignal mit einem durch den Benutzer festlegbaren Rauschsignal, wobei beispielsweise die Rauschart und der Pegel des von der Rauscheinheit 15a, 15b erzeugten Rauschsignals durch den Benutzer auswählbar ist.

Über eine die Addiereinheiten 14a und 14b verbindende Schalteinheit 16 können anstatt einer separaten Verbindung der jeweiligen Fadingeinheit 13a bzw. 13b mit der zugeordneten Rauscheinheit 15a bzw. 15b die Ausgangssignale der Fadingeinheiten 13a, 13b auch addiert und jeweils einer der beiden Rauscheinheiten 15a bzw. 15b zugeführt werden. Die I/Q-Ausgangssignale am Ausgang der Rauscheinheiten 15a bzw. 15b sind an Buchsen 17a und 18a bzw. 17b und 18b auskoppelbar.

Die Ausgangssignale der Rauscheinheiten 17a und 17b sind über Addier- und Schalteinheiten 19a und 19b I/Q-Modulatoren 20a bzw. 20b zuführbar. Auch hier besteht über eine Schalteinheit 21 die Möglichkeit, die Ausgangssignale der Rauscheinheiten 15a und 15b zu addieren und einem der beiden I/Q-Modulatoren 20a bzw. 20b zuzuführen. Auch hinsichtlich der Funktion des I/Q-Modulators 20a, 20b bestehen mehrere benutzerspezifische Auswahlmöglichkeiten. Beispielsweise kann der I/Q-Modulator 20a, 20b so betrieben werden, daß dieser eine Burst-Sequenz erzeugt und die aktiven Bursts bzw. die Pegel der aktiven Bursts durch die Benutzer ausgewählt werden können.

Die I/Q-Modulatoren 20a und 20b sind jeweils mit einer Hochfrequenzeinheit 22a bzw. 22b verbunden und das Hochfrequenzsignal kann an einer Buchse 23a bzw. 23b abgenommen werden. Beispielsweise können die Ausgangsfrequenz oder mehrere im Frequenzsprungverfahren angesprungene Ausgangsfrequenzen der Hochfrequenzeinheit 22a und 22b durch den Benutzer ausgewählt werden.

Zusätzlich ist eine Signalanzeige 24 vorhanden, die über Schalteinheiten 25a bzw. 25b im Ausführungsbeispiel mit dem Ausgang der Rauscheinheit 15a oder der Rauscheinheit 15b verbindbar ist. Alternativ ist es auch denkbar, daß die Anzeigeeinrichtung 24 direkt mit den Ausgängen der Basisbandeinheiten 2a und 2b verbindbar ist. Die Signalanzeige 24 ermöglicht beispielsweise die Darstellung des Konstellationsdiagramms, so daß der Benutzer die Wirkungsweise des geschalteten Signalpfads überprüfen kann.

Ferner ist ein Bitfehlerratentester (BERT = Bit Error Rate Tester) 26 vorgesehen, dessen Eingangsbuchse 27 ein Signal des Prüflings (DUT) zuführbar ist, wobei an der Ausgangsbuchse 28 die Bitfehlerrate des Signals abgenommen werden kann.

Es können auch noch weitere Funktionseinheiten vorhanden sein und es können weitere Kombinationsvarianten der Funktionseinheiten möglich sein, die aufgrund der Übersichtlichkeit nicht dargestellt sind.

Alle vorstehend beschriebenen Funktionseinheiten 2a, 2b, 6, 8, 9, 10a, 10b, 11a, 11b, 12a, 12b, 13a, 13b, 14a, 14b, 15a, 15b, 16, 19a, 19b, 20a, 20b, 21, 22a, 22b, 24 und 26 sind mit einer Steuereinrichtung 34, beispielsweise einer CPU, über einen Steuerbus 29a, dessen Verbindung mit den Funktionseinheiten über das Symbol (*) gekennzeichnet ist, verbunden. Die Steuereinheit 34 steuert die vom Benutzer gewünschte Verschaltung und Funktion der einzelnen Funktionseinheiten. Die aktuelle Verschaltung der Funktionseinheiten wird auf einer Darstellungseinrichtung (einem Display) 29, das sich zusammen mit den Bedienelementen 30 an der Frontplatte des Meßgeräts 1 befinden kann, dargestellt. Dazu ist jeder Funktionseinheit ein graphischer Funktionsblock zugeordnet und die Verbindung der Funktionseinheiten wird durch entsprechende Verbindungselemente, die die Funktionsblöcke miteinander verbinden, auf der Darstellungseinrichtung 29 dargestellt. Die Auswahl der Verbindungen der Funktionsblöcke und die Auswahl der Funktionen der Funktionsblöcke erfolgt entweder mittels eines Drehknopfs 38 und/oder entsprechenden Bedienknöpfen 32, z.B. Drucktasten, oder über ein verfahrbares Positionierungselement 33 (Maus).

Fig. 2 zeigt die Darstellungsoberfläche der Darstellungseinrichtung (Display) 29 eines ersten Funktionsbeispiels des als Signalgenerator ausgebildeten Meßgeräts 1. Erkennbar ist, daß den anhand von Fig. 1 beschriebenen Funktionseinheiten auf der Darstellungseinrichtung 29 dargestellte Funktionsblöcke entsprechen. Die Bezugszeichen der Funktionsblöcke sind jeweils um 100 gegenüber den Bezugszeichen der in Fig. 1 dargestellten Funktionseinheiten erhöht. In Fig. 2 ist ein erster Basisbandblock 102a entsprechend der ersten Basisbandeinheit 2a, ein erster Fadingblock 113a entsprechend der ersten Fadingeinheit 13a und ein erster Rauschblock 115a entsprechend der ersten Rauscheinheit 15a, ein erster I/Q-Modulator-Block 120a entsprechend dem ersten I/Q-Modulator 20a, ein erster Hochfrequenzblock 122a entsprechend der ersten Hochfrequenzeinheit 22a, ein Anzeigebereich 124 entsprechend der Signalanzeige 24 und ein Bitfehlerratentest-Block 126 und entsprechend dem Bitfehlerraten-Tester 26 als Funktionsblöcke dargestellt. Dabei entsprechen die Signal- und Daten-Ein- und Ausgänge 103a, 104a, 105a, 107, 117a, 118a, 123a, 127 und 128 den in Fig. 1 dargestellten Buchsen 3a, 4a, 5a, 7, 17a, 18a, 23a, 27 und 28.

Der Benutzer erkennt durch Blick auf die Darstellungseinrichtung 29 (das Display) die bezüglich der aktuellen Funktionen des Meßgeräts 1 ausgewählten und zusammengeschalteten Funktionseinheiten anhand der dargestellten Funktionsblöcke, die diesen Funktionseinheiten entsprechen. Ferner ist sofort erkennbar, welche Ein- und Ausgänge in welcher Weise mit Signalen belegt sind. Der interne Signalfluß und somit die Signalaufbereitung sind für den Benutzer sehr transparent dargestellt. Beispielsweise ist erkennbar, daß die Fadingeinheit 13a vor der Rauscheinheit 15a angeordnet ist, ob das Bursting des Signals im Basisband oder in der Hochfrequenz durchgeführt wird und an welchen Buchsen externe Signale angelegt werden können und wie diese auf den Signalfluß einwirken. Insbesondere wird für den Benutzer sofort erkennbar, ob eine Buchse als Ein- oder Ausgang wirkt. In den Funktionsblöcken sind die aktuellen Konfigurationen erkennbar. Besonders wichtige Parameter sind direkt in den Funktionsblöcken angezeigt. Außerdem ist für den Benutzer verdeutlicht, an welcher Stelle die Signalanzeige 24 in den Signalpfad geschaltet ist.

Wird der durch einen in der Fig. 2 schwarz dargestellten Markierungsrahmen (Markierung) 36 markierte Funktionsblock 102a selektiert, so wird nach Vorauswahl beispielsweise des "GSM/EDGE" Standards über eine Funktionsauswahlliste ein in Fig. 3 gezeigtes Dialogfenster 37 auf der Darstellungseinrichtung 29 im Vordergrund dargestellt. Innerhalb des Dialogfensters 37 sind mehrere Bedienblöcke, von denen ein Teil mit Bezugszeichen 38a, 38b, 38c dargestellt ist. Die Bedienblöcke sind ihrerseits aus meist mehreren Bedienelementen aufgebaut. In der Fig. 3 ist dies für den Bedienblock 38b gezeigt, der aus drei Bedienelementen 40a, 40b und 40c aufgebaut ist. Über einen Bedienfokus 39 ist jeweils ein Bedienblock auswählbar. Die Navigation des Bedienfokus 39 erfolgt über den Drehknopf 31 als Positionierungselement in Verbindung mit Richtungstasten 41.

Für die Bedienelemente sind verschiedene Ausführungen möglich. Im dargestellten Beispiel ist das Bedienelement 40a passiv, d.h. es ist keine Eingabe möglich, sondern es wird nur der Name des Einstellparameters angezeigt. Bei den Bedienelementen 40b und 40c sind dagegen Eingaben möglich. Hierzu kann entweder eine Eingabe über einen im Anschluß noch ausführlich erläuterten Werteeditor erfolgen, oder über ein weiteres, nicht dargestelltes Menü, wie es sich beispielsweise bei Betätigen des Bedienelements 40c, das als Schaltfläche ausgeführt ist, öffnet.

In den Figuren 4 bis 8 ist die Funktionsweise des Werteeditors anhand eines Bedienblocks 42a zum Einstellen eines Frequenzwerts erläutert. In dem dargestellten Ausschnitt der Darstellungseinrichtung 29 sind neben dem Bedienblock 42a sechs weitere Bedienblöcke 42b bis 42g gezeigt, die durch Verschieben des als schwarze Umrahmung dargestellten Bedienfokus 39 ausgewählt werden können. Die zur Bedienung des Werteeditors erforderlichen Einrichtungen sind auf der Frontplatte des Meßgeräts 1 angeordnet. Die verwendeten Bezugszeichen beziehen sich dementsprechend auf die in Fig. 3 dargestellte Frontplatte des Meßgeräts 1.

Der in der Fig. 4 dargestellte Bedienblock 42a umfaßt alle zur Einstellung einer bestimmten Frequenz, beispielsweise eines Signals des Signalgenerators, erforderlichen Elemente, so daß der Einstellparameter "Frequency 1" vollständig beschrieben ist. Hierzu ist neben dem Parameternamen 43 ein Bedienelement 45, welches als Eingabefeld für einen Zahlenwert ausgebildet ist, und ein weiteres Bedienelement 46, welches als Eingabefeld für eine physikalische Einheit ausgebildet ist, vorgesehen. Das Bedienelement 46 ist im Gegensatz zu dem Bedienelement 45 mit Werten vorbelegt, wobei aus der Vorbelegung eine Auswahl getroffen werden kann. Weiterhin ist in dem Bedienblock 42a ein Bedienelement 44 vorgesehen, durch dessen Auswahl eine bestimmte Editierfunktion des Werteeditors anwählbar ist, die nachfolgend näher beschrieben wird.

Um z.B. eine Änderung des Einstellparameters "Frequency 1" ausgehend von einer beispielhaft dargestellten Frequenz von 100.250 000 0 MHz des dargestellten Beispiels vorzunehmen, sind ein erster oder ein zweiter Editiermodus des Werteeditors einstellbar. Grundsätzlich unterscheidet sich der erste von dem zweiten Editiermodus dadurch, daß bei dem ersten Editiermodus ausgehend von dem zuletzt eingestellten Frequenzwert eine Variation des Frequenzwerts erfolgt. Dabei kann innerhalb des ersten Editiermodus zwischen einer ersten und einer zweiten Variationsfunktion gewählt werden, wobei die erste Variationsfunktion auf eine einzelne Zehnerstelle des eingestellten Frequenzwerts wirkt, die zweite Variationsfunktion dagegen den eingestellten Frequenzwert basierend auf dem zuletzt eingestellten Frequenzwert mit einer festen Schrittweite erhöht oder erniedrigt. In dem zweiten Editiermodus ist eine direkte Eingabe eines Zahlenwerts für die Frequenz möglich.

Der Werteeditor wird jeweils für denjenigen Bedienblock eingeschaltet, der durch den Bedienfokus 39 hervorgehoben ist. Der erste Editiermodus wird dabei durch Betätigen eines Auswahlmittels eingeschaltet. Als Auswahlmittel kann z.B. eine Eingabetaste 52 oder ein in den Drehknopf 31 integrierter Drucktaster ausgebildet sein. Mit dem Aktivieren des ersten Editiermodus ist als Voreinstellung die erste Variationsfunktion aufgerufen. Auf der Darstellungseinrichtung 29 wird dies, wie in Fig. 5 dargestellt, dadurch angezeigt, daß einem Eingabefokus 47 eine Ziffer des numerisch dargestellten Werts des Einstellparameters "Frequency 1" unterlegt ist.

Bei aufgerufener erster Variationsfunktion ist jeweils das Zeichen einer alphanumerischen Zeichenkette in dem Bedienelement 45 veränderbar, das durch den Eingabefokus 47 hervorgehoben ist. Die Veränderung erfolgt dabei durch Drehen des Drehknopfs 31. Mit jedem Puls, der durch den als Impulsgeber ausgeführten Drehknopf 31 abgegeben wird, wird das unterlegte Zeichen um den Wert "eins" erhöht oder erniedrigt, je nach Drehung des Drehknopfs 31 im oder gegen den Uhrzeigersinn. Für einen numerischen Wert führt dies entsprechend zu einer Addition oder Subtraktion des Zahlenwerts "eins" von der betreffenden Ziffer. Bei einer alphanumerischen Zeichenkette erfolgt die Veränderung eines Zeichens entsprechend den benachbarten Buchstaben des Alphabets, wobei die Buchstaben des Alphabets um Sonderzeichen erweitert sein können. Die Änderung des durch den Eingabefokus 47 unterlegten Zeichens ist anstelle des Drehknopfs 31 auch durch das wiederholte Drücken der Richtungstasten 41c oder 41d möglich.

Bei einem numerisch dargestellten Wert kann durch Erhöhen des Werts einer Zehnerstelle zu einem Zahlenüberlauf kommen, wenn ausgehend von einer "neun" eine weitere Erhöhung der betreffenden Zehnerstelle vorgenommen wird. Für die übergeordneten Zehnerstellen wird dann eine automatische Anpassung vorgenommen. Entsprechend werden die von einem Zahlenunterlauf betroffenen Zehnerstellen ebenfalls angepaßt.

Innerhalb der Zeichenkette wird der Eingabefokus 47 mit Richtungstasten 41a und 41b um jeweils eine Stelle verrückt. Das dem unterlegten Zeichen rechte oder linke benachbarte Zeichen wird so mit dem Eingabefokus 47 unterlegt und eine Verschiebung des Eingabefokus 47 ist schrittweise bis zu der Stelle des zu ändernden Zeichens möglich.

Durch Betätigen einer Umschalttaste (Toggle-Taste) 48 wird die zweite Variationsfunktion aufgerufen und das Schrittweitensymbol des Bedienelements 44 wie in Fig. 6 dargestellt mit dem Eingabefokus 47 unterlegt. Bei aufgerufener zweiter Variationsfunktion wird durch Drehen des Drehknopfs 31 der in dem Bedienelement 45 dargestellte Zahlenwert des Einstellparameters für jeden durch den Drehknopf 31 erzeugten Puls in einer vorbestimmten Schrittweite verändert. Bei Aufrufen der zweiten Variationsfunktion ist die Schrittweite bereits festgelegt. Die Schrittweite kann z.B. über ein Konfigurationsmenü bestimmt werden. Ein Erhöhen oder Erniedrigen des Zahlenwerts des Bedienelements 45 erfolgt in Abhängigkeit von der Drehrichtung des Drehknopfs 31. Anstelle der Verwendung des Drehknopfs 31 zum Einstellen des gewünschten Werts des Bedienelements 45 ist wiederum die Verwendung der Richtungstasten 41c und 41d möglich. Bei erneuter Betätigung der Drucktasterfunktion des Drehknopfs 31 oder der Eingabetaste 52 wird der erste Editiermodus verlassen und durch Navigation des Bedienfokus 39 ist ein Wechsel zu einem weiteren Einstellparameter oder in den zweiten Editiermodus möglich.

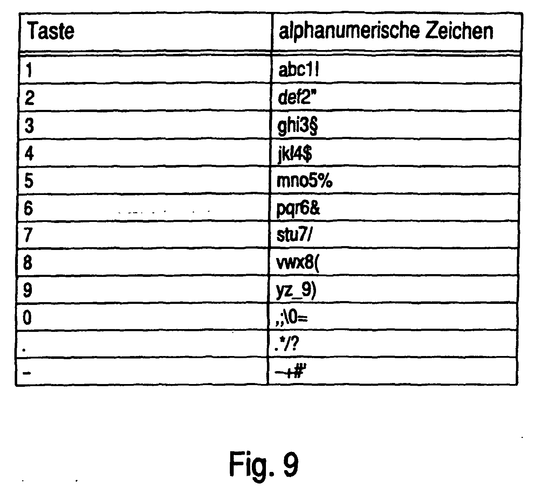

Ist ein Bedienblock durch den Bedienfokus 39 ausgewählt und der erste Editiermodus nicht eingeschaltet, so wird durch Eingabe eines ersten Zeichens über das Tastaturfeld 49 der zweite Editiermodus eingeschaltet. Bei Einschalten des zweiten Editiermodus wird die in dem Bedienelement 45 angezeigte Zeichenkette gelöscht. Durch Eingabe einer Folge von Zeichen über das Tastaturfeld 49 ist der gewünschte Wert, im dargestellten Beispiel der Fig. 7, ein Zahlenwert für den Einstellparameter "Frequency 1" direkt eingebbar und wird in dem Anzeigenfeld des Bedienelements 45 angezeigt. Zur Eingabe einer Folge von Buchstaben sind die einzelnen Tasten des Tastaturfelds 49 mehrfach belegt, so daß durch repetierendes Drücken einer Taste verschiedene Zeichen eingebbar sind. Eine beispielhafte Belegung des in Fig. 3 dargestellten Tastaturfelds 49 ist in der Tabelle der Fig. 9 dargestellt.

Nach Eingabe eines Zahlenwerts für die einzustellende Frequenz "Frequency 1" wird die Eingabe für den Einstellparameter durch Festlegen einer physikalischen Einheit abgeschlossen. Dem Bediener des Meßgeräts 1 stehen hierzu zwei Möglichkeiten offen. In dem zweiten Editiermodus ist eine direkte und indirekte Eingabe der physikalischen Einheit möglich. Die direkte Eingabe erfolgt über drei Einheitentasten 50a bis 50c. Die physikalisch Grundeinheit ist für den Einstellparameter festgelegt und ist für den Einstellparameter "Frequency 1" "Hertz". Über die Einheitentasten wird eine Skalierung der Grundeinheit vorgenommen. Hierzu sind die Einheitentasten 50a bis 50c mit jeweils zwei Bedeutungen hinterlegt, so daß durch mehrfachen Tastendruck zwischen den beiden Bedeutungen umgeschaltet werden kann. Die Einheitentaste 50a schaltet beispielsweise zwischen den Bedeutungen "Nano" und "Giga" um. Der eingegebene Zahlenwert für den Einstellparameter wird dann mit der der Eingabe "Nano" oder "Giga" entsprechenden Zehnerpotenz skaliert. Für die Einheitentaste 50b sind die Bedeutungen "Mikro" und "Mega" und für die Einheitentaste 50c die Bedeutungen "Milli" und "Kilo" vorgesehen. Die Verteilung der Bedeutungen der Einheitentasten 50a bis 50c ist eine Skalierung mit Faktoren von 10⁻⁹ bis 10⁺⁹ möglich. Dabei sind die Skalierungsfaktoren den Einheitentasten 50a bis 50c so zugeordnet, daß jeweils Exponenten gleicher Größe mit entgegengesetztem Vorzeichen gemeinsam eine Einheitentaste 50a, 50b oder 50c belegen. Mit der Eingabe einer Einheit über eine der Einheitentasten 50a, 50b oder 50c und der damit verbundenen Übernahme des Skalierungsfaktors durch die Steuereinheit, wird der zweite Editiermodus beendet und der Bedienfokus 39 kann zu einem Bedienblock eines anderen Einstellparameters verschoben werden.

Alternativ ist die Auswahl einer Einheit über eine Auswahlliste 46a möglich. Das Bedienelement 46 ist hierzu mit einer bezüglich des zugeordneten Einstellparameters ausgewählten Vorbelegung versehen. Die Auswahlliste 46a wird durch Betätigung der Umschalttaste 48 angezeigt. Gleichzeitig wird der Eingabefokus 47 in die Auswahlliste 46a versetzt, so daß die momentan eingestellte Einheit durch den Eingabefokus 39 unterlegt ist. Durch Drehen des Drehknopfs 31 ist der Eingabefokus 39 innerhalb der Auswahlliste 46a verschiebbar. Unterlegt der Eingabefokus die gewünschte Einheit, so kann durch Drücken des Drehknopfs 31 oder Drücken der Eingabetaste 52, die unterlegte Einheit selektiert werden. Analog zu der Auswahl einer Einheit mittels der Einheitentasten 50a bis 50c wird der zweite Editiermodus auch bei Auswahl einer Einheit über die Auswahlliste 46a des Bedienelements 46 verlassen. Anstelle der Umschalttaste 48 kann die Auswahlliste 46a auch durch Drücken der Richtungstaste 41b angezeigt werden.

Ist eine Änderung der Einheit nicht erforderlich, weil die zuletzt eingestellte Einheit für den neu eingegebenen Zahlenwert ebenfalls Gültigkeit besitzt, kann die Auswahl der Einheit auch entfallen. Der zweite Editiermodus wird dann durch Betätigen des Auswahlmittels, z.B. der Eingabetaste 52 verlassen. Wird vor dem Verlassen des Editiermodus eine Abbruchtaste 51 betätigt, so wird der vor Änderung des eingestellten Zahlenwerts eingestellte Zahlenwert wieder hergestellt.

Sowohl der erste als auch der zweite Editiermodus sind bei Betätigen der Abbruchtaste 51 zu jedem Zeitpunkt zu verlasen In dem zweiten Editiermodus werden dabei die zuletzt vor der Änderung eingestellten Zahlenwerte und Einheiten wieder eingestellt und die Markierung eines neuen Bedienblock 42a bis 42g ist wieder durch Verschieben des Bedienfokus 39 möglich.

## Patentansprüche

1. Meßgerät mit
mehreren Funktionseinheiten (2a, 2b, 6, 13a, 13b, 15a, 15b, 20a, 20b, 22a, 22b), wobei für zumindest einen Teil der Funktionseinheiten (2a, 2b, 6, 13a, 13b, 15a, 15b, 20a, 20b, 22a, 22b) mehrere Einstellparameter einstellbar sind und die Änderung der Werte der Einstellparameter über Bedienelemente (43, 44, 45, 46) eingebbar ist,
einer Steuereinrichtung (34), die die Einstellung der Einstellparameter steuert, und
einer optischen Darstellungseinrichtung (29), auf der die Bedienelemente (43, 44, 45, 46) darstellbar sind,
wobei mehrere Bedienelemente (43, 44, 45, 46) gemeinsam als Bedienblock (42a,...42g) zusammenwirken,
und
wobei zur Eingabe einer Änderung von in des Bedienelementen alphanumerisch dargestellten Werten von Einstellparametern zwischen zumindest zwei Editiermodi des Werteeditors umgeschaltet werden kann,
**dadurch gekennzeichnet,**
**dass** der aktive Bedienblock (42a) durch einen Bedienfokus (39) gegenüber weiteren Bedienblöcken (42b, ..., 42g) hervorgehoben ist,
**dass** der Werteeditor für jeweils denjenigen Bedienblock (42a) eingeschaltet wird, der durch den Bedienfokus (39) hervorgehoben ist und
**dass** zur Eingabe einer Änderung der in den Bedienelementen (43, 44, 45, 46) alphanumerisch dargestellten Werte von Einstellparametern innerhalb des Bedienfokus (39) zwischen den zumindest zwei Editiermodi des Werteeditors umgeschaltet werden kann.

2. Meßgerät nach Anspruch 1,
**dadurch gekennzeichnet,**
**daß** ein erster Editiermodus eine erste Variationsfunktion und eine zweite Variationsfunktion umfaßt und beide Variationsfunktionen durch Betätigen einer Umschalttaste (48) wechselweise aufrufbar sind.

3. Meßgerät nach Anspruch 2,
**dadurch gekennzeichnet,**
**daß** bei aufgerufener erster Variationsfunktion durch Betätigen eines Impulsgebers (31, 41) dasjenige Zeichen einer in einem Bedienelement (45) dargestellten alphanumerischen Zeichenkette veränderbar ist, auf das ein Eingabefokus (47) gesetzt ist.

4. Meßgerät nach Anspruch 3,
**dadurch gekennzeichnet,**
**daß** der Eingabefokus (47) durch Betätigen von Richtungstasten (41a, 41b) auf jeweils ein benachbartes Zeichen der alphanumerischen Zeichenkette versetzbar ist.

5. Meßgerät nach Anspruch 3 oder 4,
**dadurch gekennzeichnet,**
**daß** eine korrekte Änderung von durch Zahlenüberlauf oder Zahlenunterlauf betroffenen Zehnerstellen eines numerisch dargestellten Werts des Bedienelements (45) bei Änderung des Werts einer Zehnerstelle automatisch erfolgt.

6. Meßgerät nach einem der Ansprüche 2 bis 5,
**dadurch gekennzeichnet,**
**daß** bei aufgerufener zweiter Variationsfunktion ein in einem Bedienelement (45) numerisch dargestellter Wert eines Einstellparameters durch Betätigen eines Impulsgebers (31, 41) in einer vorbestimmbaren festen Schrittweite änderbar ist.

7. Meßgerät nach einem der Ansprüche 2 bis 6,
**dadurch gekennzeichnet,**
**daß** die aufgerufene zweite Variationsfunktion durch Hervorheben eines Symbols eines Bedienelements (44) durch den Eingabefokus (47) anzeigbar ist.

8. Meßgerät nach einem der Ansprüche 1 bis 7,
**dadurch gekennzeichnet,**
**daß** bei einem eingeschalteten zweiten Editiermodus eine in einem Bedienelement (45) angezeigte alphanumerische Zeichenkette durch Eingabe einer Folge von Zeichen mittels eines Tastaturfelds (49) überschreibbar ist.

9. Meßgerät nach Anspruch 8,
**dadurch gekennzeichnet,**
**daß** bei Eingabe eines ersten Zeichens mittels des Tastaturfelds (49) die zu überschreibende Zeichenkette des Bedienelements (45) gelöscht wird.

10. Meßgerät nach Anspruch 8 oder 9,
**dadurch gekennzeichnet,**
**daß** bei eingeschaltetem zweiten Editiermodus zur Auswahl einer physikalischen Einheit eines Einstellparameters durch Betätigen einer Umschalttaste (48) eine Auswahlliste (46a) von physikalischen Einheiten anzeigbar ist.

11. Meßgerät nach Anspruch 10,
**dadurch gekennzeichnet,**
**daß** bei eingeschaltetem zweiten Editiermodus die physikalische Einheit durch Drücken einer Einheitentaste (50a, 50b, 50c) direkt einstellbar ist.

12. Meßgerät nach Anspruch 10 oder 11,
**dadurch gekennzeichnet,**
**daß** der numerisch eingegebene Wert eines Einstellparameters entsprechend der in dem Bedienelement (46) angezeigten physikalischen Einheit skalierbar ist.

13. Meßgerät nach einem der Ansprüche 10 bis 12,
**dadurch gekennzeichnet,**
**daß** die Auswahl einer physikalischen Einheit den zweiten Editiermodus beendet.

14. Meßgerät nach einem der Ansprüche 1 bis 12,
**dadurch gekennzeichnet,**
**daß** der erste oder zweite Editiermodus durch Betätigen eines Auswahlmittels (31, 52) beendbar ist.

15. Meßgerät nach einem der Ansprüche 1 bis 14,
**dadurch gekennzeichnet,**
**daß** der zweite Editiermodus durch Betätigen einer Abbruch-Taste (51) zu verlassen ist und die vor Eingabe einer Änderung angezeigten Werte der Bedienelemente (45, .46) für die Einstellparameter wieder eingestellt werden.

16. Meßgerät nach einem der Ansprüche 1 bis 15,
**dadurch gekennzeichnet,**
**daß** der durch den Bedienfokus (39) hervorgehobene Bedienblock (42a, ..., 42g) mittels des Positionierungselements (31) und/oder der Richtungstasten (41) verschiebbar ist.

17. Verfahren zur Eingabe von Werten für Einstellparameter, wobei für zumindest einen Teil der Funktionseinheiten (2a, 2b, 6, 13a, 13b, 15a, 15b, 20a, 20b, 22a, 22b) mehrere Einstellparameter einstellbar sind und die Änderung der Werte für die Einstellparameter über Bedienelemente (44, 45, 46) eingebbar ist, einer Steuereinrichtung (34), die die Einstellung der Einstellparameter steuert, und einer optischen Darstellungseinrichtung (29), auf der die Bedienelemente (43, 44, 45, 46) darstellbar sind, wobei jeweils mehrere Bedienelemente (43, 44, 45, 46) gemeinsam einen Bedienblock (38a, 38b, 38c, 42a, ..., 42g) bilden, mit folgenden Verfahrensschritten:
- Markieren eines Bedienblocks (38a, 38b, 38c, 42a, ..., 42g) durch Versetzen eines Bedienfokus (39) auf einen (42a) von mehreren Bedienblöcken (42a, ..., 42g) wobei ein Werteeditor für jeweils denjenigen Bedienblock (42a) eingeschaltet wird, der durch den Bedienfokus (39) hervorgehoben ist,
- Auswahl eines ersten oder zweiten Editiermodus des Werteeditors, und
- Änderung des eingestellten Werts eines Einstellparameters durch Variation eines in einem Bedienelement (45) des hervorgehobenen Bedienblocks (42a) alphanumerisch dargestellten Werts in dem ersten Editiermodus oder durch Überschreiben eines Zahlenwerts in dem zweiten Editiermodus.

18. Verfahren nach Anspruch 17,
**dadurch gekennzeichnet,**
**daß** in dem ersten Editiermodus durch Betätigen einer Umschalttaste (48) zwischen einer ersten Variationsfunktion und einer zweiten Variationsfunktion umgeschaltet wird.

19. Verfahren nach Anspruch 18,
**dadurch gekennzeichnet,**
**daß** bei Betätigen eines Positionierungselements (31) bei eingeschalteter erster Variationsfunktion dasjenige Zeichen einer alphanumerisch dargestellten Zeichenkette eines Bedienelements (45) verändert wird, auf das ein Eingabefokus (47) gesetzt ist.

20. Verfahren nach Anspruch 19,
**dadurch gekennzeichnet,**
**daß** der Eingabefokus (47) durch Betätigen von Richtungstasten (41a, 41b) auf das jeweils benachbarte Zeichen der Zeichenkette innerhalb des Bedienelements (45) gesetzt wird..

21. Verfahren nach einem der Ansprüche 18 bis 20,
**dadurch gekennzeichnet,**
**daß** ein numerisch dargestellter Wert bei Betätigen eines Impulsgebers (31) bei eingeschalteter zweiter Variationsfunktion für jeden Impuls um eine vorbestimmbare feste Schrittweite geändert wird und die aufgerufene zweite Variationsfunktion durch Hervorheben eines Symbols in dem Bedienelement (44) durch den Eingabefokus (47) angezeigt wird.

22. Verfahren nach einem der Ansprüche 17 bis 21,
**dadurch gekennzeichnet,**
**daß** der zweite Editiermodus durch Eingabe eines Zeichens über ein Tastaturfeld (49) eingeschaltet wird und in dem zweiten Editiermodus durch Eingabe einer Zeichenfolge über das Tastaturfeld (49) ein in einem Bedienelement (45) alphanumerisch dargestellter Wert eines Einstellparameters überschrieben wird.

23. Verfahren nach Anspruch 22,
**dadurch gekennzeichnet,**
**daß** die vor Eingabe eines ersten Zeichens in dem Bedienelement (45) dargestellte Zeichenkette bei Eingabe des ersten Zeichens über das Tastaturfeld (49) gelöscht wird.

24. Verfahren nach Anspruch 22 oder 23,
**dadurch gekennzeichnet,**
**daß** bei Betätigen einer Umschalttaste (48) in dem zweiten Editiermodus eine Auswahlliste (46a) für physikalische Einheiten angezeigt wird.

25. Verfahren nach Anspruch 22 oder 23,
**dadurch gekennzeichnet,**
**daß** eine physikalische Einheit für einen Einstellparameter bei Betätigen einer Einheitentaste (50a, 50b, 50c) direkt eingestellt wird.

26. Verfahren nach einem der Ansprüche 17 bis 25,
**dadurch gekennzeichnet,**
**daß** bei Betätigen eines Auswahlmittels (31, 42) der erste oder zweite Editiermodus beendet wird.

27. Verfahren nach einem der Ansprüche 17 bis 26,
**dadurch gekennzeichnet,**
**daß** bei Betätigen einer Abbruch-Taste (51) der erste oder zweite Editiermodus verlassen wird und die vor Änderung der Werte der Einstellparameter gültigen Werte wieder eingestellt werden.

28. Computerprogramm mit Programmcode zur Durchführung aller Verfahrensschritte nach einem der Ansprüche 17 bis 27, wenn das Programm in einem Computer oder einer Steuereinheit (34) eines Meßgeräts (1) ausgeführt wird.

29. Computerprogramm mit Programmcode, der auf einem maschinenlesbaren Träger gespeichert ist, zur Durchführung aller Verfahrensschritte des Verfahrens nach einem der Ansprüche 17 bis 27, wenn das Programm in einem Computer oder einer Steuereinheit (34) eines Meßgeräts (1) ausgeführt wird.

## Claims

1. Measuring device
with several functional units (2a, 2b, 6, 13a, 13b, 15a, 15b, 20a, 20b, 22a, 22b), wherein, for at least one part of the functional units (2a, 2b, 6, 13a, 13b, 15a, 15b, 20a, 20b, 22a, 22b), several setting parameters can be set, and the change to the values of the setting parameters can be entered via operating elements (43, 44, 45, 46),
with a control device (34), which controls the setting of the setting parameters, and
with a visual display device (29), on which the operating elements (43, 44, 45, 46) can be displayed,
wherein several operating elements (43, 44, 45, 46) cooperate jointly as an operating block (42a,... 42g) and
wherein, in order to enter a change of values of setting parameters displayed alphanumerically in the operating elements, it is possible to switch between at least two edit modes of the value editor,
**characterised in that**
the active operating block (42a) is highlighted by contrast with other operating blocks (42b, ..., 42g) by an operating frame (39),
that the value editor is switched on for the respective operating block (42a), which is highlighted by the operating frame (39) and
that, in order to enter a change to the values, displayed alphanumerically in the operating elements (43, 44, 45, 46) of setting parameters within the operating frame, it is possible to switch between the at least two edit modes of the value editor.

2. Measuring device according to claim 1,
**characterised in that**
a first edit mode comprises a first variation function and a second variation function, and that both variation functions can be opened alternately by activating a toggle key (48).

3. Measuring device according to claim 2,
**characterised in that**,
when the first variation function is open, that character of an alphanumeric character chain displayed in an operating element (45), over which an entry frame (47) is positioned, can be changed by activating a pulse generator (31, 41).

4. Measuring device according to claim 3,
**characterised in that**
the entry frame (47) can be displaced respectively to an adjacent character of the alphanumeric character chain by activating direction keys (41a, 41b).

5. Measuring device according to claim 3 or 4,
**characterised in that**
a correct change of tens digits affected by a counter overflow or counter underflow of a numerically-displayed value of the operating element (45) is implemented automatically by changing the value of a tens digit.

6. Measuring device according to any one of claims 2 to 5,
**characterised in that**,
when the second variation function is open, a value of a setting parameter displayed numerically in an operating element (45) can be changed with a predetermined, fixed step-width by activating a pulse generator (31, 41).

7. Measuring device according to any one of claims 2 to 6,
**characterised in that**
the open, second variation function can be displayed by the entry frame (47) by highlighting a symbol of an operating element (44).

8. Measuring device according to any one of claims 1 to 7,
**characterised in that**,
when a second edit mode is switched on, an alphanumeric character chain displayed in an operating element (45) can be overwritten by entering a sequence of characters by means of a keypad (49).

9. Measuring device according to claim 8,
**characterised in that**
the character chain of the operating element (45) to be overwritten is deleted, when a first character is entered by means of the keypad (49).

10. Measuring device according to claim 8 or 9,
**characterised in that**,
in order to select a physical unit of a setting parameter when the second edit mode is switched on, a selection list (46a) of physical units can be displayed by activating a toggle key (48).

11. Measuring device according to claim 10,
**characterised in that**,
when the second edit mode is switched on, the physical unit can be set directly by pressing a unit key (50a, 50b, 50c).

12. Measuring device according to claim 10 or 11,
**characterised in that**
the numerically-entered value of a setting parameter can be scaled to correspond with the physical unit displayed in the operating element (46).

13. Measuring device according to any one of claims 10 to 12,
**characterised in that**
the selection of a physical unit terminates the second edit mode.

14. Measuring device according to any one of claims 1 to 12,
**characterised in that**
the first or second edit mode can be terminated by activating a selection means (31, 52).

15. Measuring device according to any one of claims 1 to 14,
**characterised in that**
the second edit mode can be cancelled by activating a cancel key (51), and that the values of the operating elements (45, 46) for the setting parameters displayed before the entry of a change are restored.

16. Measuring device according to any one of claims 1 to 15,
**characterised in that**
the operating block (42a, ..., 42g) highlighted by the operating frame (39) can be displaced by means of the positioning element (31) and/or the direction keys (41).

17. Method for entering values for setting parameters, wherein, for at least one part of the functional units (2a, 2b, 6, 13a, 13b, 15a, 15b, 20a, 20b, 22a, 22b), several setting parameters can be set, and the change of the values for the setting parameters is entered via operating elements (44, 45, 46), with a control device (34), which controls the setting of the setting parameters, and a visual display device (29), on which the operating elements (43, 44, 45, 46) can be displayed, wherein several respective operating elements (43, 44, 45, 46) jointly form an operating block (38a, 38b, 38c, 42a, ..., 42g),
comprising the following procedural stages:
- marking of an operating block (38a, 38b, 38c, 42a, ..., 42g) by moving an operating frame (39) to one (42a) of several operating blocks (42a, ..., 42g), wherein a value editor is switched on for the respective operating block (42a), which is highlighted by the operating frame (39),
- selection of a first or second edit mode of the value editor, and
- changing of the set value of a setting parameter by variation of a value displayed alphanumerically in an operating element (45) of the highlighted operating block (42a) in the first edit mode, or by overwriting a numerical value in the second edit mode.

18. Method according to claim 17,
**characterised in that**,
in the first edit mode, it is possible to switch between a first variation function and a second variation function by activating a toggle key (48).

19. Method according to claim 18,
**characterised in that**,
with the first variation function switched on, that character of an alphanumerically-displayed character chain of an operating element (45), over which an entry frame (47) is positioned, is changed by the activation of a positioning element (31).

20. Method according to claim 19,
**characterised in that**
the entry frame (47) is set to the respective adjacent character of the character chain within the operating element (45) by activating direction keys (41a, 41b).

21. Method according to any one of claims 18 to 20,
**characterised in that**,
with a second variation function switched on, a numerically-displayed value is changed by a predeterminable, fixed step-width for each pulse by activating a pulse generator (31), and that the open, second variation function is indicated by the entry frame (47) by highlighting a symbol in the operating element (44).

22. Method according to any one of claims 17 to 21,
**characterised in that**
the second edit mode is switched on by entering a character via a keypad (49) and that, in the second edit mode, a value displayed alphanumerically in an operating element (45) of a setting parameter is overwritten by entering a character sequence via the keypad (49).

23. Method according to claim 22,
**characterised in that**
the character chain displayed before the entry of a first character in the operating element (45) is deleted, when the first character is entered via the keypad (49).

24. Method according to claim 22 or 23,
**characterised in that**,
in the second edit mode, a selection list (46a) for physical units is displayed by activating a toggle key (48).

25. Method according to claim 22 or 23,
**characterised in that**
a physical unit for a setting parameter is set directly by activating a unit key.

26. Method according to any one of claims 17 to 25,
**characterised in that**
the first or second edit mode is terminated by activating a selection means (31, 42).

27. Method according to any one of claims 17 to 26,
**characterised in that**
the first or second edit mode is cancelled by activating a cancel key (51), and that the values applicable before changing the values for the setting parameters are restored.

28. Computer program with program code for implementing all of the procedural stages according to any one of claims 17 to 27, when the program is executed in a computer or a control unit (34) of a measuring device (1).

29. Computer program with computer code, which is stored on a machine-readable carrier, for the implementation of all of the procedural stages of the method according to any one of claims 17 to 27, when the program is executed in a computer or a control unit (34) of a measuring device (1).

## Revendications

1. Appareil de mesure comprenant
plusieurs unités fonctionnelles (2a, 2b, 6, 13a, 13b, 15a, 15b, 20a, 20b, 22a, 22b), plusieurs paramètres de réglage pouvant être réglés pour au moins une partie des unités fonctionnelles (2a, 2b, 6, 13a, 13b, 15a, 15b, 20a, 20b, 22a, 22b) et la modification des valeurs des paramètres de réglage pouvant être entrés au moyen d'éléments de commande (43, 44, 45, 46),
un dispositif de commande (34), qui commande le réglage des paramètres de réglage, et
un dispositif de visualisation (29) optique, sur lequel les éléments de commande (43, 44, 45, 46) peuvent être visualisés,
plusieurs éléments de commande (43, 44, 45, 46) coopérant ensemble en tant que bloc de commande (42a, ..., 42g), et sachant qu'on peut commuter entre au moins deux modes d'édition de l'éditeur de valeurs pour entrer une modification de valeurs représentées de façon alphanumérique dans les éléments de commande de paramètres de réglage,
**caractérisé en ce que**
le bloc de commande (42a) actif est mis en évidence par un foyer de commande (39) par rapport à d'autres éléments de commande (42b, ..., 42g),
**en ce que** l'éditeur de valeurs est mis en route pour le bloc de commande (42a) respectif qui est mis en évidence par le foyer de commande (39) et
**en ce que**, pour l'entrée d'une modification des valeurs, représentées dans les éléments de commande (43, 44, 45, 46) de façon alphanumérique, de paramètres de réglage à l'intérieur du foyer de commande (39), on peut commuter entre les au moins deux modes d'édition de l'éditeur de valeurs.

2. Appareil de mesure selon la revendication 1,
**caractérisé en ce que**
un premier mode d'édition comprend une première fonction de variation et une seconde fonction de variation et les deux fonctions de variation peuvent être appelées alternativement par l'actionnement d'une touche d'inversion (48).

3. Appareil de mesure selon la revendication 2,
**caractérisé en ce que**,
lorsque la première fonction de variation est appelée, le caractère d'une chaîne de caractères alphanumériques représentée dans un élément de commande (45), sur lequel un foyer d'entrée (47) est posé, peut être modifié par l'actionnement d'un générateur d'impulsion (31, 41).

4. Appareil de mesure selon la revendication 3,
**caractérisé en ce que**
le foyer d'entrée (47) peut être déplacé sur respectivement un caractère voisin de la chaîne de caractères alphanumériques par l'actionnement de touches de direction (41a, 41b).

5. Appareil de mesure selon la revendication 3 ou 4,
**caractérisé en ce que**
une modification correcte de positions de dizaines concernées par le dépassement de capacité positif ou le dépassement de capacité négatif d'une nouvelle valeur représentée numériquement de l'élément de commande (45) s'effectue automatiquement en cas de modification de la valeur d'un chiffre de dizaine.

6. Appareil de mesure selon l'une quelconque des revendications 2 à 5,
**caractérisé en ce que**,
lorsque la seconde fonction de variation est appelée, une valeur, représentée numériquement dans un élément de commande (45), d'un paramètre de réglage peut être modifiée par l'actionnement d'un générateur d'impulsion (31, 41) dans un incrément fixe prédéfinissable.

7. Appareil de mesure selon l'une quelconque des revendications 2 à 6,
**caractérisé en ce que**,
la seconde fonction de variation appelée peut être affichée par la mise en évidence d'un symbole d'un élément de commande (44) par le foyer d'entrée (47).

8. Appareil de mesure selon l'une quelconque des revendications 1 à 7,
**caractérisé en ce que**,
lorsqu'un second mode d'édition est enclenché, une chaîne de caractères alphanumériques affichée dans l'élément de commande (45) peut être écrasée par l'entrée d'une succession de caractères au moyen d'une zone de clavier (49).

9. Appareil de mesure selon la revendication 8,
**caractérisé en ce que**,
lors de l'entrée d'un premier caractère au moyen de la zone de clavier (49), la chaîne de caractères à écraser de l'élément de commande (45) est effacée.

10. Appareil de mesure selon la revendication 8 ou 9,
**caractérisé en ce que**,
lorsque le second mode d'édition allumé est enclenché, une liste de sélections (46a) d'unités physiques peut être affichée pour le choix d'une unité physique d'un paramètre de réglage par l'actionnement d'une touche d'inversion (48).

11. Appareil de mesure selon la revendication 10,
**caractérisé en ce que**,
lorsque le second mode d'édition est enclenché, l'unité physique peut être réglée directement par l'enfoncement d'une touche d'unité (50a, 50b, 50c).

12. Appareil de mesure selon la revendication 10 ou 11,
**caractérisé en ce que**
la valeur entrée de façon numérique d'un paramètre de réglage peut être mise à l'échelle en fonction de l'unité physique affichée dans l'élément de commande (46).

13. Appareil de mesure selon l'une quelconque des revendications 10 à 12,
**caractérisé en ce que**
le choix d'une unité physique termine le second mode d'édition.

14. Appareil de mesure selon l'une quelconque des revendications 1 à 12,
**caractérisé en ce que**
le premier ou le second mode d'édition peut être terminé par l'actionnement d'un moyen de sélection (31, 52) .

15. Appareil de mesure selon l'une quelconque des revendications 1 à 14,
**caractérisé en ce que**
le second mode d'édition peut être abandonné par l'actionnement d'une touche d'interruption (51) et les valeurs, affichées avant l'entrée d'une modification, des éléments de commande (45, 46) sont réglées à nouveau pour les paramètres de réglage.

16. Appareil de mesure selon l'une quelconque des revendications 1 à 15,
**caractérisé en ce que**
le bloc de commande (42a, ..., 42g) mis en évidence par le foyer de commande (39) est coulissant au moyen de l'élément de positionnement (31) et/ou des touches de direction (41).

17. Procédé pour l'entrée de valeurs pour des paramètres de réglage, plusieurs paramètres de réglage pouvant être réglés pour au moins une partie des unités fonctionnelles (2a, 2b, 6, 13a, 13b, 15a, 15b, 20a, 20b, 22a, 22b) et la modification des valeurs pour les paramètres de réglage pouvant être entrée au moyen d'éléments de commande (44, 45, 46), d'un appareil de commande (34) qui commande le réglage des paramètres de réglage, et d'un dispositif de visualisation optique (29), sur lequel les éléments de commande (43, 44, 45, 46) peuvent être visualisés, respectivement plusieurs éléments de commande (43, 44, 45, 46) formant conjointement un bloc de commande (38a, 38b, 38c, 42a, ..., 42g)
comprenant les étapes de procédé suivantes:
- marquage d'un bloc de commande (38a, 38b, 38c, 42a, ..., 42g) par le déplacement d'un foyer de commande (39) sur un (42a) de plusieurs blocs de commande (42a, ..., 42g), un éditeur de valeurs étant enclenché pour respectivement le bloc de commande (42a) qui est mis en évidence par le foyer de commande (39),
- sélection d'un premier ou d'un second mode d'édition de l'éditeur de valeurs, et
- modification de la valeur réglée d'un paramètre de réglage par variation d'une valeur représentée de façon alphanumérique dans un élément de commande (45) du bloc de commande (42a) mis en évidence dans le premier mode d'édition ou par écrasement d'une valeur numérique dans le second mode d'édition.

18. Procédé selon la revendication 17,
**caractérisé en ce que**,
dans le premier mode d'édition, on commute par l'actionnement d'une touche d'inversion (48) entre une première fonction de variation et une seconde fonction de variation.

19. Procédé selon la revendication 18,
**caractérisé en ce que**,
en cas d'actionnement d'un élément de positionnement (31) avec la première fonction de réalisation allumée, le caractère d'une chaîne de caractères, représentée de façon alphanumérique, d'un élément de commande (45), sur lequel un foyer d'entrée (47) est posée, est modifié.

20. Procédé selon la revendication 19,
**caractérisé en ce que**
le foyer d'entrée (47) est placé par l'actionnement de touches de direction (41a, 41b) sur le caractère respectivement voisin de la chaîne de caractères à l'intérieur de l'élément de commande (45).

21. Procédé selon l'une quelconque des revendications 18 à 20,
**caractérisé en ce que**
une valeur représentée de façon numérique est modifiée d'un incrément fixe prédéfinissable pour chaque impulsion en cas d'actionnement d'un générateur d'impulsion (31) avec une seconde fonction de variation enclenchée et la seconde fonction de variation appelée est affichée par le foyer d'entrée (47) en mettant en évidence un symbole dans l'élément de commande (44).

22. Procédé selon l'une quelconque des revendications 17 à 21,
**caractérisé en ce que**
le second mode d'édition est enclenché par l'entrée d'un caractère au moyen d'une zone de clavier (49) et, dans le second mode d'édition, une valeur, représentée de façon alphanumérique dans un élément de commande (45), d'un paramètre réglage est écrasée par l'entrée d'une succession de caractères au moyen de la zone de clavier (49).

23. Procédé selon la revendication 22,
**caractérisé en ce que**
la chaîne de caractères représentée avant l'entrée d'un premier caractère dans l'élément de commande (45) est effacée lors de l'entrée du premier caractère au moyen de la zone de clavier (49).

24. Procédé selon la revendication 22 ou 23,
**caractérisé en ce que**,
en cas d'actionnement d'une touche d'inversion (48) dans le second mode d'édition, une liste de sélection (46a) est affichée pour des unités physiques.

25. Procédé selon la revendication 22 ou 23,
**caractérisé en ce que**
une unité physique pour un paramètre de réglage est réglée directement en cas d'actionnement d'une touche d'unité (50a, 50b, 50c).

26. Procédé selon l'une quelconque des revendications 17 à 25,
**caractérisé en ce que**,
en cas d'actionnement d'un moyen de sélection (31, 42), le premier ou le second mode d'édition est achevé.

27. Procédé selon l'une quelconque des revendications 17 à 26,
**caractérisé en ce que**,
en cas d'actionnement d'une touche d'interruption (51), le premier ou le second mode d'édition est abandonné et les valeurs valables avant la modification des valeurs des paramètres de réglage sont rétablies.

28. Programme informatique avec code de programme pour la réalisation de toutes les étapes du procédé selon l'une quelconque des revendications 17 à 27, lorsque le programme est exécuté dans un ordinateur ou une unité de commande (34) d'un appareil de mesure (1).

29. Programme informatique avec code de programme, qui est mémorisé sur un support lisible à la machine, pour la réalisation de toutes les étapes du procédé selon l'une quelconque des revendications 17 à 27 lorsque le programme est exécuté dans un ordinateur ou une unité de commande (34) d'un appareil de mesure (1).
